# EUROPÄISCHE PATENTSCHRIFT

(11) **EP 2 619 283 B1**
(45) Veröffentlichungstag und Bekanntmachung des Hinweises auf die Patenterteilung: **16.07.2014**
(21) Anmeldenummer: 12705801.4
(22) Anmeldetag: 24.02.2012
(51) Int. Cl.: C09K 11/77

(54) **SILICAT-LEUCHTSTOFFE**
SILICATE FLUORESCENT SUBSTANCE
SUBSTANCES FLUORESCENTES À BASE DE SILICATE

(30) Priorität: 18.03.2011 EP 11002247
(43) Veröffentlichungstag der Anmeldung: 31.07.2013
(73) Patentinhaber: Merck Patent GmbH, 64293 Darmstadt (DE)
(72) Erfinder: VOSGROENE, Tim, 64372 Ober-Ramstadt (DE); DEGENRING, Daniela, 64579 Gernsheim (DE); SCHLUETER, Stefan, 64404 Bickenbach (DE); HESS, Sascha, 68649 Gross-Rohrheim (DE); OPOLKA, Andrea, 18516 Suederholz (DE); HEIDEN, Eric, 17489 Greifswald (DE)
(86) Internationale Anmeldenummer: PCT/EP2012/000814
(87) Internationale Veröffentlichungsnummer: WO 2012/126561

(56) Entgegenhaltungen:
- WO-A1-2004/067677
- US-A- 4 451 757
- US-A1- 2005 199 897

## Beschreibung

Die Erfindung betrifft Silicat-Verbindungen enthaltend Alkaliborat, Verfahren zur Herstellung dieser Verbindungen und deren Verwendung als Konversionsleuchtstoffe bzw. in Leuchtmitteln.

Anorganische fluoreszente Pulver, welche im blauen und/oder UV Bereich des Spektrums anregbar sind, gewinnen immer stärkere Bedeutung als Leuchtstoffe für sog. phosphorkonvertierte (phosphor converted) LEDs, kurz pc-LEDs.

Mittlerweile sind viele Leuchtstoffmaterialsysteme bekannt, beispielsweise Erdalkali-orthosilicate, Thiogallate, Granate und Nitride, die jeweils mit Cer³⁺ oder Eu²⁺ dotiert sind.

Europium-dotierte Erdalkali-ortho-Silicate wurden bereits 1968 von T. Barry zum ersten Mal beschrieben (T.L. Barry, J. Electrochem. Soc. (1968), 115(11), 1181-4).

In den letzten zehn Jahren wurden diese Verbindungen in immer größerem Umfang in pc- LEDs eingesetzt. Der große Vorteil dieser sehr effizienten Leuchtstoffe besteht dabei darin, dass durch Variation der Zusammensetzung ein Emissionswellenlängenbereich von 505 bis 610 nm zugänglich ist.

Ein Nachteil dieser Materialien ist allerdings ihre Empfindlichkeit gegenüber Feuchtigkeit. Insbesondere Verbindungen mit einem hohen Bariumanteil im Kristallgitter hydrolisieren bei Kontakt mit Wasser allmählich. Dies führt zu einem Abbau des Kristallgitters, wodurch der Leuchtstoff drastisch an Intensität verliert.

EP 0019710 beschreibt einen filterbeschichteten Leuchtstoff wie z.B. Sulfide, der mit Filterteilchen aus Pigmenten versehen ist, wobei die Pigmente mit Metallborat beschichtet sind. Die Boratbeschichtung dient dazu, die Haftung der Pigmentteilchen auf dem Leuchtstoff zu erhöhen.

WO 02/054502 beschreibt Erdalkali-ortho-silicate, die neben Phosphorpentoxid, Aluminiumoxid oder Germaniumoxid auch Boroxid (B₂O₃) enthalten, wobei Bor teilweise auf dem Gitterplatz von Silicium eingebaut wird.

Dokument US2005/199897 offenbart Verbindungen der Formel (Sr,Ba,Ca)₂SiO₄:Eu, Mischungen mit weiteren Leuchtstoffen, sowie deren Verwendung als Konversionsleuchtstoff und in Lichtquellen und Anzeigevorrichtungen.

Aufgabe der vorliegenden Erfindung ist es, bestimmte Erdalkali-ortho-silicat-Leuchtstoffe zu entwickeln, die eine gute Stabilität gegen Feuchtigkeit besitzen.

Eine weitere Aufgabe der vorliegenden Erfindung besteht darin, ein Verfahren zur Herstellung dieser Erdalkali-ortho-silicat-Leuchtstoffe zur Verfügung zu stellen.

Zusätzlich besteht eine Aufgabe der Erfindung auch darin, eine Mischung aus dem genannten Erdalkali-ortho-silicat-Leuchtstoff mit weiteren Leuchtstoffen bereit zu stellen.

Darüber hinaus besteht eine weitere Aufgabe der Erfindung darin, verschiedene Verwendungsmöglichkeiten für diese Leuchtstoffe aufzuzeigen.

Überraschenderweise wurde nun gefunden, dass Erdalkali-ortho-silicat-Leuchtstoffe, insbesondere Europium-dotierte Erdalkali-ortho-silicat-Leuchtstoffe, welche Alkaliborat (M₂B₄O₇) enthalten, die oben genannte Aufgabe erfüllen.

Gegenstand der vorliegenden Erfindung ist daher eine Verbindung der Formel I,

EA₂₋ₓEuₓSiO₄ • a M₂B₄O₇ (I)

wobei
- EA: für zwei oder mehrere Elemente, ausgewählt aus Ca, Sr, Zn und Ba steht,
- M: für Li, Na oder K steht, und
- a: für einen Wert aus dem Bereich 0.01 ≤ a ≤ 0.08 und
- x: für einen Wert aus dem Bereich 0.01 ≤ x ≤ 0.25 steht.

Vorzugsweise steht M für Na oder K, insbesondere bevorzugt für Na. Vorzugsweise steht EA für Ba und Sr. Es sind aber auch Ausführungsformen möglich, bei denen EA für Ba und Sr und Ca und solche Ausführungsformen, bei denen EA für Ba und Sr und Zn steht. Besonders bevorzugt sind jedoch Ausführungsformen der vorliegenden Erfindung, bei denen EA für Ba und Sr steht. Dabei ist es ganz besonders bevorzugt, wenn das Verhältnis Ba:Sr im Bereich von 0,4-1,2, insbesondere im Bereich von 0,7-1,1 liegt.

Vorzugsweise steht a für einen Wert aus dem Bereich 0.01 ≤ a ≤ 0.05. Vorzugsweise steht x für einen Wert aus dem Bereich 0.03 ≤ x ≤ 0.20, insbesondere bevorzugt für einen Wert aus dem Bereich 0.04 ≤ x ≤ 0.13.

In der erfindungsgemäßen Verbindung gemäß Formel I liegt Europium ausschließlich in divalenter Form vor.

Die Verbindungen der Formel I stellen Leuchtstoffe dar, deren Emissionswellenlängenbereich von 505 bis 610 nm beträgt und damit unverändert ist im Vergleich zu den Emissionswellenlängen von Leuchtstoffen der Zusammensetzung EA₂₋ₓEuₓSiO₄, wobei EA für zwei oder mehrere Elemente, ausgewählt aus Ca, Sr, Zn und Ba, steht und x für einen Wert aus dem Bereich 0.01 ≤ x ≤ 0.25 steht.

Demzufolge ermöglichen sie Emissionsfarben in Bereich von Orange über Gelb bis Grün.

Im Kontext dieser Anmeldung wird als grünes Licht solches Licht bezeichnet, dessen Intensitätsmaximum zwischen 505 und 545 nm Wellenlänge liegt, als gelbes Licht solches Licht, dessen Intensitätsmaximum zwischen 545 und 565 nm Wellenlänge liegt, als oranges Licht solches Licht, dessen Intensitätsmaximum zwischen 565 und 600 nm Wellenlänge liegt und als rotes Licht solches Licht, dessen Maximum zwischen 600 und 670 nm Wellenlänge liegt.

Die Anregbarkeit der erfindungsgemäßen Leuchtstoffe erstreckt sich über einen weiten Bereich, der von etwa 410 nm bis 530nm, bevorzugt 430 nm bis zu etwa 500 nm reicht. Damit sind diese Leuchtstoffe nicht nur zur Anregung durch UV oder blau emittierende Lichtquellen wie LEDs oder konventionelle Energieentladungslampen (zum Beispiel auf Hg-Basis) geeignet, sondern auch für Lichtquellen, welche die blaue In³+-Linie bei 451 nm ausnutzen.

Im Folgenden werden die erfindungsgemäßen Verbindungen der Formel I vereinfachend auch als Silicat-Leuchtstoffe bezeichnet.

Die erfindungsgemäßen Silicat-Leuchtstoffe weisen eine erstaunlich hohe Beständigkeit gegenüber dem Kontakt mit Feuchtigkeit auf, wie weiter unter noch näher erläutert werden wird, und sind nach einem einfachen Verfahren herstellbar.

Ein weiterer Erfindungsgegenstand ist daher ein Verfahren zur Herstellung einer Verbindung der Formel I, umfassend folgende Verfahrensschritte:
a) Bereitstellung einer M₂B₄O₇-haltigen Lösung , wobei M = Li, Na oder K bedeutet (Lösung A)
b) Bereitstellen eines Leuchtstoffes der Zusammensetzung EA₂₋ₓEuₓSiO₄, wobei EA für zwei oder mehrere Elemente, ausgewählt aus Ca, Sr, Zn und Ba, steht und x für einen Wert aus dem Bereich 0.01 ≤ x ≤ 0.25 steht (Leuchtstoff B)
c) Zugabe und inniges Vermischen des Leuchtstoffes B mit der Lösung A,
d) Waschen, und
e) anschließende Trocknung.

Das molare Verhältnis von M₂B₄O₇ aus Schritt a) und EA₂₋ₓEuₓSiO₄ aus Schritt b) wird dabei so eingestellt, dass sich ein Wert a aus Formel I im Bereich von 0.01 bis 0.08, vorzugsweise von 0.01 bis 0.05, ergibt. Um dies zu erhalten, wird ein geigneter Überschuss an Alkaliborat für die Reaktion bereitgestellt. Diesen kann der Fachmann in einfacher Weise aus seinem Fachwissen heraus bestimmen.

Das Waschen gemäß Schritt c) erfolgt erfindungsgemäß vorzugsweise mittels eines wasserlöslichen Lösemittels wie beispielsweise Ethanol, Methanol oder Aceton. Insbesondere bevorzugt wird Ethanol eingesetzt.

Die Bereitstellung einer M₂B₄O₇-haltigen Lösung erfolgt vorzugsweise aus kommerziell erhältlichen Salzen (wie z.B. Na₂B₄O₇ der Fa. Merck), die vorzugsweise in Wasser gelöst eingesetzt werden.

Leuchtstoffe der Zusammensetzung EA₂₋ₓEuₓSiO₄, wobei EA für zwei oder mehrere Elemente, ausgewählt aus Ca, Sr, Zn und Ba steht, und x für einen Wert aus dem Bereich 0.01 ≤ x ≤ 0.25 steht, sind an sich bekannt und kommerziell verfügbar.

Sie werden nach bekannten Verfahren hergestellt, und zwar vorzugsweise durch Mischen von Europium- und Siliciumhaltigen Verbindungen (vorzugsweise Oxide, Carbonate oder Oxalate) mit Barium- und Strontium- , und wahlweise Calcium- oder Zink-haltigen Materialien (ebenfalls bevorzugt Oxide, Carbonate oder Oxalate), in der Regel unter Zugabe mindestens eines weiteren anorganischen oder organischen Stoffes, der üblicherweise als Flussmittel eingesetzt wird, und der thermischen Behandlung des Gemisches. Besonders bevorzugt werden jeweils die Oxide oder Carbonate von jeweils Europium, Silicium, Barium, Strontium, Zink und/oder Calcium eingesetzt.

Die genannte thermische Behandlung wird bevorzugt zumindest teilweise unter reduzierenden Bedingungen durchgeführt. Die Umsetzung erfolgt dabei üblicherweise bei einer Temperatur oberhalb 800 °C, vorzugsweise oberhalb 1200 °C, insbesondere bevorzugt zwischen 1300 und 1500 °C.

Die zumindest teilweise reduzierenden Bedingungen werden dabei z.B. (reduzierend) mit Kohlenmonoxid, Formiergas oder Wasserstoff, oder (teilweise reduzierend) zumindest per Vakuum oder durch eine Sauerstoffmangel-Atmosphäre eingestellt. Bevorzugt wird eine reduzierende Atmosphäre mittels einer Stickstoff/Wasserstoff-Atmosphäre und insbesondere bevorzugt im N₂/H₂ -Strom (90 - 70 : 10 - 30) eingestellt.

Als Flussmittel werden wahlweise mindestens ein Stoff aus der Gruppe der Ammoniumhalogenide, vorzugsweise Ammoniumchlorid, Erdalkalifluoride wie Calcium-, Strontium- oder Bariumfluorid, Carbonate, vorzugsweise Ammoniumhydrogencarbonat, oder verschiedene Alkoholate und/oder Oxalate eingesetzt. Für den Fall des Einsatzes der genannten Erdalkali fluoride als Flussmittel muss jedoch deren Anteil am stöchiometrischen Verhältnis der Komponenten gemäß Formel EA₂₋ₓEuₓSiO₄ (EA und x wie vorab beschrieben) mit einbezogen werden. Besonders bevorzugt wird Ammoniumchlorid eingesetzt.

Die Herstellung der Leuchtstoffe gemäß Formel EA₂₋ₓEuₓSiO₄ (EA und x wie vorab beschrieben) erfolgt dabei vorzugsweise über eine Festkörper-diffusionsmethode (ausgehend z.B. von Oxiden, Carbonaten oder Oxalaten der entsprechenden Erdalkalimetalle, Alkalimetalle oder Seltenerden). Es sind jedoch auch Verfahren bekannt, mittels derer die Leuchtstoffe über nasschemische Methoden aus den entsprechenden anorganischen und/oder organischen Salzen über ein Sol-Gel-Verfahren, Copräzipitations- und /oder Trocknungsverfahren hergestellt werden können.

Die Bereitstellung der Leuchtstoffe gemäß Formel EA₂₋ₓEuₓSiO₄ (EA und x wie vorab beschrieben) für Schritt b) des oben beschriebenen erfindungsgemäßen Herstellungsverfahrens kann unmittelbar vor der erfindungsgemäßen Umsetzung mit einer M₂B₄O₇-haltigen Lösung (Bedeutung von M wie vorab beschrieben) erfolgen und damit als Vorstufe in das erfindungsgemäße Verfahren integriert werden, oder auch wahlweise in einem größerem zeitlichen Abstand zum erfindungsgemäßen Verfahren erfolgen. Wie bereits vorab erwähnt, handelt es sich hier um handelsübliche Produkte.

Die erfindungsgemäßen Silicat-Leuchtstoffe können auch mit anderen Leuchtstoffen, und zwar, insbesondere wenn sie einen vergleichweise hohen relativen Anteil an Barium (λₘₐₓ <545 nm) aufweisen bevorzugt mit rot-emittierenden Leuchtstoffen, gemischt werden, wodurch sich solche Mischungen sehr gut für Anwendungen in der Allgemeinbeleuchtung (z.B. für warm-weiße LEDs) und LCD-backlighting eignen.

Eine weiterer Gegenstand der vorliegenden Erfindung ist daher eine Mischung, enthaltend mindestens eine Verbindung der Formel I und mindestens einen weiteren Leuchtstoff, vorzugsweise einen rot-emittierenden Leuchtstoff.

Dabei wird der rot-emittierende Leuchtstoff vorzugsweise ausgewählt aus Eu-dotierten Sulfoseleniden und Eu- und/oder Ce-dotierten Nitriden, Oxynitriden, Alumosiliconitriden und/oder Mn(IV) dotierten Oxiden und/oder Fluoriden. Dabei kann es insbesondere bevorzugt sein, wenn der rot-emittierende Leuchtstoff ausgewählt ist aus den nitridischen Leuchtstoffen, vorzugsweise (Ca,Sr,Ba)₂Si₅N₈:Eu, (Ca,Sr)AlSiN₃:Eu, A₂-0,5_{y-x} Euₓ Si₅ N_{8-y} O_{y}, wobei A für ein oder mehrere Elemente ausgewählt aus Ca, Sr und Ba, x für einen Wert aus dem Bereich von 0,005 bis 1 und y für einen Wert aus dem Bereich von 0,01 bis 3 steht, oder Varianten der genannten Verbindungen, bei denen einzelne Gitterpositionen durch andere chemische Elemente, wie Alkalimetalle, Aluminium, Gallium, oder Gadolinium, substituiert sind bzw. solche weiteren Elemente als Dotierstoff Fehlstellen besetzen. Dem Fachmann bekannte und geeignete Materialsysteme stellen Siliconitride und Alumosilikonitride dar (vgl. Xie, Sci. Technol. Adv. Mater. 2007, 8, 588-600), 2-5-8-Nitride, wie das (Ca,Sr,Ba)₂Si₅N₈:Eu²⁺ (Li et al., Chem. Mater. 2005, 15, 4492) und Alumosiliconitride, wie das (Ca,Sr)AlSiN₃:Eu²⁺ (K. Uheda et al., Electrochem. Solid State Lett. 2006, 9, H22).

Besonders bevorzugt wird als rot-emittierender Leuchtstoff ein Leuchtstoff der Verbindung A_{2-0,5y-x} Euₓ Si₅ N_{8-y} O_{y} eingesetzt, wobei A für ein oder mehrere Elemente ausgewählt aus Ca, Sr und Ba steht und x für einen Wert aus dem Bereich von 0,005 bis 1 steht, und y für einen Wert aus dem Bereich von 0,01 bis 3 steht. Verbindungen dieser Art sind in der Patentanmeldung PCT/EP2010/007954 genauer beschrieben und werden nachfolgend als Verbindung gemäß Formel II bezeichnet. Dabei kann die Verbindung der Formel II als Reinstoff oder im Gemisch mit mindestens einer weiteren Silicium und Sauerstoff enthaltenden Verbindung vorliegen, wobei es bevorzugt ist, wenn die mindestens eine weitere Silicium und Sauerstoff enthaltende Verbindung ein Reaktionsnebenprodukt der Herstellung der Verbindung der Formel II ist und diese die anwendungsreleventen optischen Eigenschaften der Verbindung der Formel II nicht nachteilig beeinflusst. In den Verbindungen der Formel II steht A in bevorzugten Ausführungsformen für Sr, während x in bevorzugten Ausführungsformen für einen Wert aus dem Bereich von 0,01 bis 0,8 steht, vorzugsweise aus dem Bereich 0,02 bis 0,7 und besonders bevorzugt aus dem Bereich 0,05 bis 0,6, und insbesondere bevorzugt aus dem Bereich 0,1 bis 0,4, und y in bevorzugten Ausführungsformen für einen Wert aus dem Bereich von 0,1 bis 2,5 steht, vorzugsweise aus dem Bereich 0,2 bis 2 und insbesondere bevorzugt aus dem Bereich 0,22 bis 1,8.

Zur Herstellung von Leuchtstoffen der Formel II werden in einem ersten Verfahrensschritt geeignete Edukte, ausgewählt aus binären Nitriden und Oxiden oder entsprechenden reaktiven Formen dazu gemischt und das Gemisch in einem zweiten Verfahrensschritt unter reduktiven Bedingungen thermisch behandelt. Bei dieser thermischen Behandlung ist es bevorzugt, wenn sie zumindest teilweise unter reduzierenden Bedingungen durchgeführt wird. Im zweiten Verfahrensschritt erfolgt die Umsetzung üblicherweise bei einer Temperatur oberhalb 800 C, vorzugsweise bei einer Temperatur oberhalb 1200°C und insbesondere bevorzugt im Bereich von 1400°C - 1800°C. Die reduktiven Bedingungen werden dabei z.B. mit Kohlenmonoxid, Formiergas oder Wasserstoff oder zumindest Vakuum oder Sauerstoffmangel-Atmosphäre eingestellt, bevorzugt im Stickstoffstrom, vorzugsweise im N₂/H₂ -Strom und insbesondere bevorzugt im N₂/H₂/NH₃-Strom eingestellt. Soll die Verbindungen der Formel II rein hergestellt werden, so kann dies entweder über genaue Kontrolle der Eduktstöchiometrie oder durch mechanisches Abtrennen der Kristalle der Verbindungen der Formel II von den glasartigen Anteilen erfolgen. Die Abtrennung kann beispielsweise über die unterschiedliche Dichte, Partikelform oder Partikelgröße nach dem Fachmann bekannten Trennmethoden erfolgen.

In der erfindungsgemäßen Mischung von mindestens einem Leuchtstoff gemäß der Formel I und mindestens einem weiteren Leuchtstoff, insbesondere mindestens einem rot-emittierenden Leuchtstoff, beträgt das Verhältnis von Leuchtstoffen gemäß Formel I und dem oder den weiteren Leuchtstoffen erfindungsgemäß 20:1 bis 1:1, bezogen auf das Gesamtgewicht der Leuchtstoffe. Dabei ist es erfindungsgemäß bevorzugt, wenn der mindestens eine Leuchtstoff der Formel I und der mindestens eine weitere Leuchtstoff, insbesondere der mindestens eine rot-emittierende Leuchtstoff, im Gewichtsverhältnis 10:1 bis 3:1 und insbesondere bevorzugt 6:1 bis 4:1 vorliegen, bezogen auf das Gesamtgewicht dieser Leuchtstoffe.

Die erfindungsgemäßen Silicat-Leuchtstoffe gemäß Formel I liegen partikulär vor und weisen eine Partikelgröße auf, die üblicherweise zwischen 50 nm und 30 µm, vorzugsweise zwischen 1 µm und 20 µm beträgt.

Die erfindungsgemäßen Leuchtstoffpartikel können auch eine Oberfläche aufweisen, die funktionelle Gruppen trägt, welche eine chemische Anbindung an die Umgebung, vorzugsweise bestehend aus Epoxy oder Silikonharz ermöglicht. Diese funktionellen Gruppen können z.B. über Oxogruppen angebundene Ester oder andere Derivate sein, die mit Bestandteilen der Bindemittel auf Basis von Epoxiden und / oder Silikonen Verknüpfungen eingehen können. Solche Oberflächen haben den Vorteil, dass eine homogene Einmischung der Leuchtstoffe in das Bindemittel ermöglicht wird. Des Weiteren können dadurch die rheologischen Eigenschaften des Systems Leuchtstoff / Bindemittel und auch die Topfzeiten in einem gewissen Masse eingestellt werden. Damit wird die Verarbeitung der Gemische vereinfacht.

Die erfindungsgemäßen Silicat-Leuchtstoffe sind insbesondere vorteilhaft in Licht emittierenden Dioden (LEDs), und insbesondere in den vorab bereits erwähnten pc-LEDs einsetzbar.

Zum Einsatz in LEDs können die erfindungsgemäßen Silicat-Leuchtstoffe auch in beliebige weitere äußere Formen, wie sphärische Partikel, Plättchen sowie strukturierte Materialien und Keramiken überführt werden. Diese Formen werden gewöhnlich unter dem Begriff "Formkörper" zusammengefasst. Vorzugsweise handelt es sich bei dem Formkörper hier um einen "Leuchtstoffkörper". Besonders bevorzugt werden die erfindungsgemäßen Silicat-Leuchtstoffe gemäß Formel I daher in Formkörpern, respektive in Leuchtstoffkörpern, enthaltend die erfindungsgemäßen Silicat-Leuchtstoffe, eingesetzt.

Die Herstellung von keramischen Leuchtstoffkörpern, enthaltend die erfindungsgemäßen Silicat-Leuchtstoffe , erfolgt vorzugsweise analog nach dem in der DE 10349038 beschriebenen Verfahren. Die genannte Patentschrift wird daher voll umfänglich in den Kontext der vorliegenden Anmeldung durch Bezugnahme eingefügt. Dabei wird der Leuchtstoff isostatisch verpresst und in Form eines homogenen dünnen und nicht porösen Plättchens direkt auf die Oberfläche eines Chips aufgebracht. Somit findet keine ortsabhängige Variation der Anregung und Emission des Leuchtstoffes statt, wodurch die damit ausgerüstete LED einen homogenen und farbkonstanten Lichtkegel emittiert und über eine hohe Lichtleistung verfügt. Die keramischen Leuchtstoffkörper können z.B. als Plättchen in Dicken von einigen 100 nm bis zu etwa 500 µm großtechnisch hergestellt werden. Die Plättchenausdehnung (Länge x Breite) ist von der Anordnung abhängig. Bei direkter Aufbringung auf den Chip ist die Größe des Plättchens gemäß der Chipausdehnung (von ca. 100 µm * 100 µm bis zu mehreren mm²) mit einem gewissen Übermaß von ca. 10% - zu 30% der Chipoberfläche bei geeigneter Chipanordnung (z.B. Flip-Chip-Anordnung) oder entsprechend zu wählen. Wird das Leuchtstoffplättchen über einer fertigen LED angebracht, so ist der austretende Lichtkegel vollständig vom Plättchen zu erfassen.

Die Seitenflächen des keramischen Leuchtstoffkörpers können mit einem Leicht- oder Edelmetall, vorzugsweise Aluminium oder Silber verspiegelt werden. Die Verspiegelung bewirkt, dass kein Licht lateral aus dem Leuchtstoffkörper austritt. Lateral austretendes Licht kann den aus der LED auszukoppelnden Lichtstrom verringern. Die Verspiegelung des keramischen Leuchtstoffkörpers erfolgt in einem Prozessschritt nach der isostatischen Verpressung zu Stangen oder Plättchen, wobei vor der Verspiegelung eventuell ein Schneiden der Stangen oder Plättchen in die erforderliche Größe erfolgen kann. Die Seitenflächen werden hierzu z.B. mit einer Lösung aus Silbernitrat und Glucose benetzt und anschließend bei erhöhter Temperatur einer Ammoniak-Atmosphäre ausgesetzt. Hierbei bildet sich z.B. ein silberner Belag auf den Seitenflächen aus.

Alternativ bieten sich auch stromlose Metallisierungsverfahren an, siehe beispielsweise Hollemann-Wiberg, Lehrbuch der Anorganischen Chemie, Walter de Gruyter Verlag oder Ullmanns Enzyklopädie der chemischen Technologie.

Der keramische Leuchtstoffkörper kann, falls erforderlich, mit einer Wasserglaslösung auf einem LED Chip, welcher als Untergrund dient, fixiert werden.

In einer bevorzugten Ausführung besitzt der keramische Leuchtstoffkörper auf der einem LED Chip entgegengesetzten Seite eine strukturierte (z.B. pyramidale) Oberfläche. Somit kann möglichst viel Licht aus dem Leuchtstoffkörper ausgekoppelt werden. Die strukturierte Oberfläche auf dem Leuchtstoffkörper wird dadurch hergestellt, in dem beim isostatischen Verpressen das Presswerkzeug eine strukturierte Pressplatte aufweist und dadurch eine Struktur in die Oberfläche prägt. Strukturierte Oberflächen sind dann gewünscht, wenn möglichst dünne Leuchtstoffkörper bzw. Plättchen hergestellt werden sollen. Die Pressbedingungen sind dem Fachmann bekannt (siehe J. Kriegsmann, Technische keramische Werkstoffe, Kap. 4, Deutscher Wirtschaftsdienst, 1998). Wichtig ist, dass als Presstemperaturen 2/3 bis zu 5/6 der Schmelztemperatur des zu verpressenden Stoffes verwendet werden.

Es sind jedoch auch Ausführungsformen für das Aufbringen der erfindungsgemäßen Silicat-Leuchtstoffe auf eine Leuchtdiode möglich (siehe Beispiel 4, GaN-Chip als LED-Chip), bei denen eine aufzubringende Leuchtstoffschicht, die die erfindungsgemäßen Silicat-Leuchtstoffe enthalten soll, im Volumenguss aufgebracht wird, vorzugsweise im Volumenguss aus einem Gemisch von Silikon und homogenen Silicat-Leuchtstoffpartikeln.

Ein weiterer Gegenstand der vorliegenden Erfindung ist eine Lichtquelle, welche einen Halbleiter und mindestens eine Verbindung nach Formel I enthält.

Besonders bevorzugt ist dabei eine Lichtquelle, welche einen Halbleiter und mindestens eine Verbindung nach Formel I, sowie mindestens einen anderen, rot emittierenden Leuchtstoff enthält. Vorzugsweise ist diese Lichtquelle weiß emittierend oder emittiert Licht mit einem bestimmten Farbpunkt (Color-on-demand-Prinzip).

Als rot-emittierende Leuchtstoffe werden dabei bevorzugt die vorab bereits genauer beschriebenen rot-emittierenden Leuchtstoffe eingesetzt.

Unter dem color-on-demand Konzept versteht man die Realisierung von Licht eines bestimmten Farbpunktes mit einer pc-LED (= phosphor converted LED) unter Einsatz eines oder mehrer Leuchtstoffe.

In einer bevorzugten Ausführungsform der erfindungsgemäßen Lichtquelle handelt es sich bei dem Halbleiter um ein lumineszentes IndiumAluminium-GalliumNitrid, insbesondere der Formel InᵢGaⱼAlₖN, wobei 0 ≤ i, 0 ≤ j, 0 ≤ k, und i+j+k=1 ist.

In einer weiteren bevorzugten Ausführungsform der erfindungsgemäßen Lichtquelle handelt es sich bei der Lichtquelle um eine lumineszente, auf ZnO, TCO (Transparent conducting oxide), ZnSe oder SiC basierende Anordnung, oder auch um eine auf einer organischen lichtemittierenden Schicht basierende Anordnung (OLED).

In einer weiteren bevorzugten Ausführungsform der erfindungsgemäßen Lichtquelle handelt es sich bei der Lichtquelle um eine Quelle, die Elektrolumineszenz und/oder Photolumineszenz zeigt. Weiterhin kann es sich bei der Lichtquelle auch um eine Plasma- oder Entladungsquelle handeln.

Dem Fachmann sind mögliche Formen von derartigen Lichtquellen bekannt. Es kann sich hierbei um lichtemittierende LED-Chips unterschiedlichen Aufbaus handeln.

Die erfindungsgemäßen Silicat-Leuchtstoffe können entweder in einem Harz dispergiert (z.B. Epoxy oder Siliconharz), oder bei geeigneten Größenverhältnissen direkt auf der Lichtquelle angeordnet werden, oder aber von dieser, je nach Anwendung, entfernt angeordnet sein (letztere Anordnung schließt auch die "Remote phosphor Technologie" mit ein). Die Vorteile der "Remote phosphor Technologie" sind dem Fachmann bekannt und z.B. der folgenden Publikation zu entnehmen: Japanese Journ of Appl. Phys. Vol. 44, No. 21 (2005) L649-L651.

Ein weiterer Erfindungsgegenstand ist eine Beleuchtungseinheit, insbesondere zur Hintergrundbeleuchtung von Anzeigevorrichtungen, die mindestens eine vorab beschriebene Lichtquelle und damit mindestens einen Silicat-Leuchtstoff gemäß Formel I enthält. Solche Beleuchtungseinheiten werden hauptsächlich in Anzeigevorrichtungen, insbesondere Flüssigkristallanzeigevorrichtungen (LC Display), mit einer Hintergrundbeleuchtung, eingesetzt, Daher ist auch eine derartige Anzeigevorrichtung Gegenstand der vorliegenden Erfindung.

Die optische Ankopplung der oben beschriebenen Beleuchtungseinheit zwischen dem Silicat-Leuchtstoff oder dem den erfindungsgemäßen Silicat-Leuchtstoff enthaltenden Leuchtstoffgemisch und dem Halbleiter kann auch durch eine lichtleitende Anordnung realisiert werden. Dadurch ist es möglich, dass an einem zentralen Ort der Halbleiter installiert wird und dieser mittels lichtleitender Vorrichtungen, wie beispielsweise lichtleitenden Fasern, an den Leuchtstoff optisch angekoppelt ist. Auf diese Weise lassen sich den Beleuchtungswünschen angepasste Leuchten lediglich bestehend aus einem oder unterschiedlichen Leuchtstoffen, die zu einem Leuchtschirm angeordnet sein können, und einem Lichtleiter, der an die Lichtquelle angekoppelt ist, realisieren. Auf diese Weise ist es möglich, eine starke Lichtquelle an einen für die elektrische Installation günstigen Ort zu platzieren und ohne weitere elektrische Verkabelung, sondern nur durch Verlegen von Lichtleitern an beliebigen Orten Leuchten aus Leuchtstoffen, welche an die Lichtleiter gekoppelt sind, zu installieren.

Ein weiterer Gegenstand der vorliegenden Erfindung ist die Verwendung der erfindungsgemäßen Leuchtstoffe als Konversionsleuchtstoff, vorzugsweise zur teilweisen oder vollständigen Konversion der blauen oder im nahen UV-liegenden Emission einer Lumineszenzdiode.

Weiterhin bevorzugt ist die Verwendung der erfindungsgemäßen Leuchtstoffe zur Konversion der blauen oder im nahen UV-liegenden Emission in sichtbare weiße Strahlung.

Die Verwendung der erfindungsgemäßen Silicat-Leuchtstoffe ist erfindungsgemäß auch in Elektrolumineszenz-Materialien, wie beispielsweise Elektrolumineszenz-Folien (auch Leuchtfolien oder Lichtfolien genannt), in denen beispielsweise Zinksulfid oder Zinksulfid dotiert mit Mn²⁺, Cu⁺, oder Ag⁺ als Emitter eingesetzt wird, die im gelb-grünen Bereich emittieren, vorteilhaft. Die Anwendungsbereiche der Elektrolumineszenz-Folie sind z.B. Werbung, Displayhintergrund-beleuchtung in Flüssigkristallbildschirmen (LC-Displays) und Dünnschichttransistor-Displays (TFT-Displays), selbstleuchtende KFZ-Kennzeichenschilder, Bodengrafik (in Verbindung mit einem tritt- und rutschfesten Laminat), in Anzeigen- und/oder Bedienelementen beispielsweise in Automobilen, Zügen, Schiffen und Flugzeugen oder auch Haushalts-, Garten-, Mess- oder Sport- und Freizeitgeräten.

Die erfindungsgemäßen Silicat-Leuchtstoffe ergeben, in LEDs in geringen Mengen eingesetzt, bereits gute LED-Qualitäten.

Die erfindungsgemäßen Silicat-Leuchtstoffe gemäß Formel I weisen, im Vergleich zu handelsüblichen Silicat-Leuchtstoffen der Formel EA₂₋ₓEuₓSiO₄, wobei EA für zwei oder mehrere Elemente, ausgewählt aus Ca, Sr, Zn und Ba, steht und x für einen Wert aus dem Bereich 0.01 ≤ x ≤ 0.25 steht, eine ausgezeichnete Beständigkeit gegen Feuchtigkeit auf, die das Absinken der Intensität des Leuchtstoffes über einen längeren Zeitraum bei Kontakt zu Luftfeuchtigkeit nachhaltig verringert. Dies gilt insbesondere dann, wenn der Gehalt an Barium in den erfindungsgemäßen Leuchtstoffen vergleichsweise hoch ist, was ohne die erfindungsgemäße Zugabe von Alkaliboraten eine besondere Anfälligkeit gegen Feuchtigkeit in der Anwendung nach sich ziehen würde. Außerdem weisen die erfindungsgemäßen Silicat-Leuchtstoffe Emissionsspektren auf, deren Maximum gegenüber dem Emissionsmaximum von nicht mit Alkaliboraten behandelten handelsüblichen Silicat-Leuchtstoffen weder verschoben noch vermindert ist. Sie lassen sich daher mit gutem Erfolg in allen üblichen Anwendungsmedien einsetzten, in denen übliche Silicat-Leuchtstoffe eingesetzt werden.

Die folgenden Beispiele sollen die vorliegende Erfindung verdeutlichen. Sie sind jedoch keinesfalls als limitierend zu betrachten. Alle Verbindungen oder Komponenten, die in den Zubereitungen verwendet werden können, sind entweder bekannt und kommerziell erhältlich, oder können nach bekannten Methoden synthetisiert werden. Die in den Beispielen angegebenen Temperaturen gelten immer in °C. Es versteht sich weiterhin von selbst, dass sich sowohl in der Beschreibung als auch in den Beispielen die zugegebenen Mengen der Komponenten in den Zusammensetzungen immer zu insgesamt 100% addieren. Gegebene Prozentangaben sind immer im gegebenen Zusammenhang zu sehen. Sie beziehen sich üblicherweise aber immer auf die Masse der angegebenen Teil- oder Gesamtmenge.

Auch ohne weitere Ausführungen wird davon ausgegangen, dass ein Fachmann die obige Beschreibung in weitestem Umfang nutzen kann. Die bevorzugten Ausführungsformen sind deswegen lediglich als beschreibende, keinesfalls als in irgendeiner Weise limitierende Offenbarung aufzufassen. Die vollständige Offenbarung aller vor- und nachstehend aufgeführten Anmeldungen und Veröffentlichungen sind durch Bezugnahme in diese Anmeldung eingeführt.

### Beispiel 1: Herstellung von Sr_{0.9}Ba_{1.02}Eu_{0.08}SiO₄ · 0.02 Na₂B₄O₇

Der erfindungsgemäße Leuchtstoff mit der Zusammensetzung (Sr_{0.9}Ba_{1.02} Eu_{0.08}SiO₄ • 0,02 Na₂B₄O₇) wird in zwei Synthesestufen hergestellt.

### Stufe 1: Herstellung des Orthosilicat-Leuchtstoffes mit der Zusammensetzung Sr_{0.9}Ba_{1.02}Eu_{0.08}SiO₄

Die Ausgangsstoffe BaCO₃, SrCO₃, Eu₂O₃ und SiO₂ werden im angegebenen stöchiometrischen Verhältnis zusammen mit kleinen Mengen des Flussmittels NH₄Cl (ca. 5% w/w) intensiv gemischt. Anschließend wird das Ausgangsgemisch in Korundtiegel gefüllt und in einem Hochtemperaturofen bei 1350 C in unter reduzierender Atmosphäre für 6 Stunden geglüht. Nach Abkühlung des Glühgutes wird dieses zerkleinert, mit Wasser gewaschen, getrocknet und gesiebt.

### Stufe 2: Herstellung des erfindungsgemäßen Orthosilicat-Leuchtstoffes mit der Zusammensetzung Sr_{0.9}Ba_{1.02}Eu_{0.08}SiO₄ • 0,02 Na₂B₄O₇

### Zunächst werden 50g Na₂B₄O₇ (wasserfrei, zur Analyse, Merck, Art.-Nr. 1.06306.0250) in 2 I VE-Wasser gelöst. (Lösung A)

Für die Herstellung des Leuchtstoffes werden 500g des unbehandelten Leuchtstoffes Sr_{0.9}Ba_{1.02}Eu_{0.08}SiO₄ in die Lösung A eingetragen und für 60 min gerührt. Anschließend wird die Leuchtstoffsuspension über eine Nutsche abgesaugt, mit Ethanol gewaschen und im Trockenschrank bei ca. 100°C getrocknet.

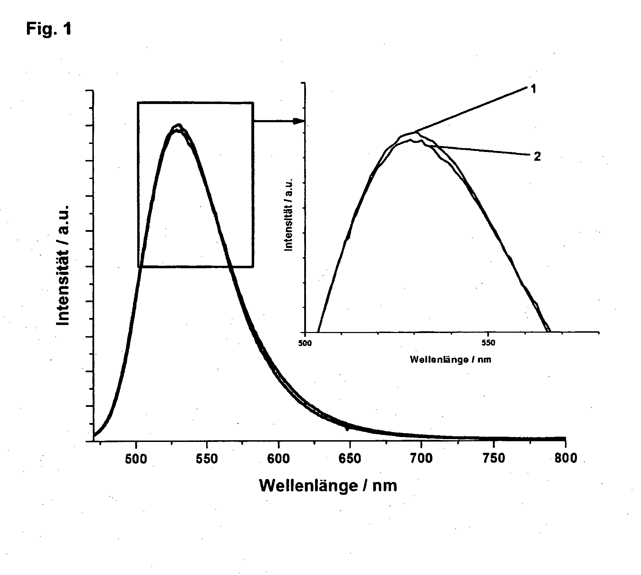

Es wird ein grüner Silicat-Leuchtstoff mit einem Emissionsmaximum von ca. 530 nm gemäß Figur 1 (Spektrum 2) erhalten.

### Darstellung von nitridischen Leuchtstoffen für Mischungen

### Beispiel 2A: Herstellung eines rot emittierenden Leuchtstoffs Sr₂Si₅N₈:Eu

1,84 g Sr₃N₂, 0,166 g EuN und 2,33 g Siliciumnitrid werden in einer mit Stickstoff gefüllten Glovebox eingewogen und vermischt. Das entstandene Gemisch wird in einen Molybdäntiegel gefüllt und in einen Rohrofen überführt. Anschließend wird das Gemisch 8 Stunden bei 1600 °C unter einer Stickstoff/Wasserstoffatmosphäre kalziniert. Nach Abkühlung wird der Rohleuchtstoff entnommen, kurz gemörsert und erneut in einen Molybdäntiegel gefüllt, der dann in einen Hochdruckofen überführt wird. In diesem wird der Leuchtstoff erneut 8 Stunden bei 1600 °C unter einem Stickstoffdruck von 65 bar kalziniert.
Nach Abkühlung wird der Leuchtstoff entnommen und in 100 ml VE-Wasser suspendiert. Die entstehende Suspension wird 30 Minuten gerührt, anschließend wird der Rührer ausgeschaltet. Nach einigen Minuten wird der Überstand abgegossen, der verbleibende Rückstand wird erneut in VE-Wasser aufgenommen, abgenutscht, mit VE-Wasser neutral gewaschen und getrocknet.

### Beispiel 2B: Herstellung eines rot emittierenden Leuchtstoffs (Sr,Ca)AlSiN₃:Eu

2,22 g Sr₃N₂, 0,33g Ca₃N₂, 0,05 g EuN, 1,23 g AIN und 1,4 g Siliciumnitrid werden in einer mit Stickstoff gefüllten Glovebox eingewogen und vermischt. Das entstandene Gemisch wird in einen Bornitrid-Tiegel gefüllt und in eine heißisostatische Presse (HIP) überführt. Es wird ein Stickstoffdruck von 500 bar eingestellt, anschließend wird das Material auf 1700 °C erhitzt und 4 Stunden bei dieser Temperatur getempert, hierbei steigt der Druck auf 1740 bar. Nach Abkühlung und Ventilation wird das Material entnommen und in 100 ml VE-Wasser suspendiert. Die entstehende Suspension wird 30 Minuten gerührt, anschließend wird der Rührer ausgeschaltet. Nach einigen Minuten wird der Überstand abgegossen, der verbleibende Rückstand wird erneut in VE-Wasser aufgenommen, abgenutscht, mit VE-Wasser neutral gewaschen und getrocknet.

### 3. Herstellung von Leuchtstoffmischungen

### Beispiel 3 : Sr_{0.9}Ba_{1.02}Eu_{0.08} SiO₄ • 0,02 Na₂B₄O₇ und Nitrid-basierender Leuchtstoff

### Beispiel 3 A:

10 g des erfindungsgemäßen Leuchtstoffes aus Stufe 2 von Beispiel 1 werden mit 1 g des Leuchtstoffes aus Beispiel 2A innig vermischt.

### Beispiel 3 B:

Analog Beispiel 3 A wird eine Mischung enthaltend die Leuchtstoffe aus Stufe 2 von Beispiel 1 und aus Beispiel 2B hergestellt.

### Beispiel 4: Herstellung einer Leuchtdiode

Die Leuchtstoffmischung aus Beispiel 3A wird in einem Taumelmischer mit einem 2-Komponenten Silikon (OE 6550 der Fa. Dow Corning) gemischt, so dass gleiche Mengen der Leuchtstoffmischung in den beiden Komponenten des Silikons dispergiert sind; die Gesamtkonzentration der Leuchtstoffmischung im Silikon beträgt 8 Gew.-%.

5 ml jeder der beiden Leuchtstoff enthaltenden Silikon Komponenten werden homogen miteinander gemischt und in einen Dispenser überführt. Mit Hilfe des Dispensers werden leere LED-Packages der Fa. OSA optoelectronics, Berlin, welche einen 100 µm² großen GaN Chip enthalten, befüllt. Danach werden die LEDs in eine Wärmekammer gestellt, um über 1 h bei 150°C das Silikon zu verfestigen.

| **Zusammensetzung** | **Emissions-max. [nm]** | **CIE 1931 x, y** | **Quantenausbeute bei 435 nm^{*}** | **Lumenäquivalent [lm/W]** |
|---|---|---|---|---|
| Sr_{0.9}Ba_{1.02}Eu_{0.08}SiO₄ • 0.02 Na₂B₄O₇ | 527.3 | 0.299 | 96% | 496,7 |
| | | 0.629 | | |
| Sr_{0.9}Ba_{1.02}Eu_{0.08}SiO₄ | 527.1 | 0.299 | 97% | 496,9 |
| | | 0.629 | | |

| | | | | |
|---|---|---|---|---|
| *^{*} Quantenausbeute wurde aus den Emissionsspektren und den Reflexionsgraden bei 435 nm ermittelt* | | | | |

**Tab. 1** zeigt die optischen Eigenschaften des erfindungsgemäßen Silicat-Leuchtstoffs aus Stufe 2 von Beispiel 1 im Vergleich zu einem bekannten Silicat-Leuchtstoff gemäß Stufe 1 aus Beispiel 1.

CIE x und CIE y stehen für die Koordinaten in dem dem Fachmann geläufigen CIE Normfarbdiagramm (hier Normalbeobachter 1931), mit denen die Farbe einer Lichtquelle beschrieben wird. Alle oben aufgeführten Größen werden nach dem Fachmann geläufigen Methoden aus Emissionsspektren der Lichtquelle berechnet.

Das Lumenäquivalent (Im/W) ergibt sich aus dem Produkt des normierten Emissionsspektrum I (lambda) mit der Augenempfindlichkeitskurve V(lamda).

### Beispiel 5: Klimatests zur Überprüfung der Stabilität der Leuchtstoffe gegenüber Feuchtigkeit

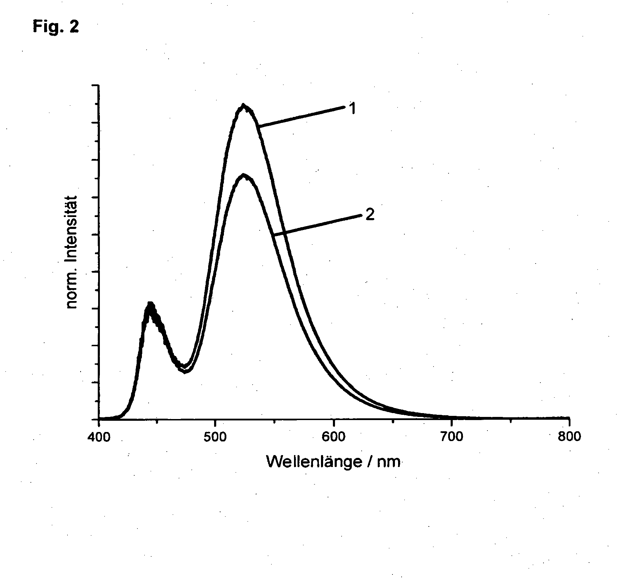

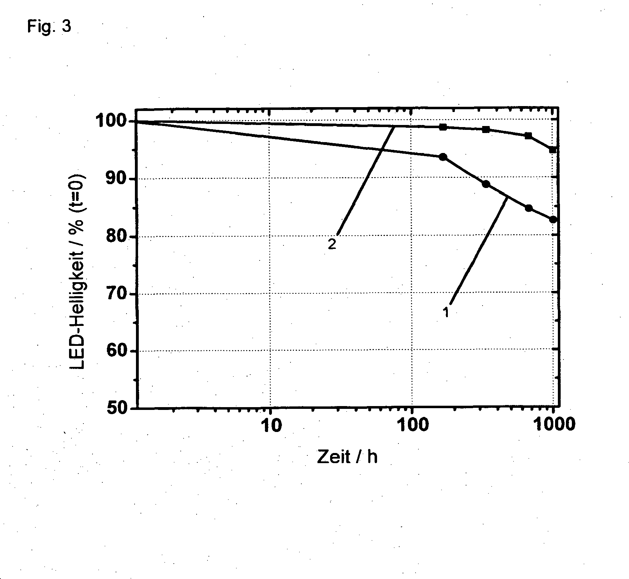

Die Klimatests mit den o-Silicat-Leuchtstoffen aus den Stufen 1 und 2 des Beispiels 1 werden in einem Klimaprüfschrank des Typs LHL 113 der Fa. Thermotec durchgeführt. Dazu werden je 10 LEDs des Package-Typs PLCC2 mit den zu vergleichenden Leuchtstoffen befüllt. Zum Befüllen wird eine Suspension aus handelsüblichen LED-Siliconharz und 15% w/w des jeweiligen Leuchtstoffes verwendet. Über einen Zeitraum von 1000 h, einer relativen Luftfeuchtigkeit von 85 ± 3% und einer Temperatur von 80 ± 1 °C werden die mit 20 mA konstant bestromten LEDs im Klimaprüfschrank getestet. Die Ergebnisse sind in den folgenden Spektren (siehe Fig. 2 und 3) wiedergegeben. Es zeigt sich, dass die erfindungsgemäßen Leuchtstoffe enthaltend Na₂B₄O₇ (Kurve 2 in Figur 3) im Vergleich zu den Leuchtstoffen ohne Na₂B₄O₇ stabiler gegen Feuchtigkeit sind.

### Beschreibung der Figuren

- **Fig. 1:**: zeigt einen Vergleich der Emissionsspektren von Leuchtstoffen der Zusammensetzung Sr_{0.9}Ba_{1.02}Eu_{0.08}SiO₄ (Spektrum 1) und Sr_{0.9}Ba_{1.02}Eu_{0.08}SiO₄ • 0.02 Na₂B₄O₇ (Spektrum 2). Die beiden Spektren werden an einer halbunendlich dicken Pulverschicht mit einem Edinburgh Instruments FL900 Spektrometer unter Verwendung einer Xe-Hochdrucklampe und eines Hamamatsu Photomultipliers bei Raumtemperatur aufgenommen.
- **Fig. 2:**: zeigt verschiedene Spektren einer LED, in der der ortho-Silicat-leuchtstoff aus Stufe 1 von Beispiel 1 (ohne Natriumtetraborat) eingesetzt und dem oben beschriebenen Klimatest unterzogen wird. Das Spektrum 1 zeigt das Emissionsspektrum zum Zeitpunkt t = 0, das Spektrum 2 zeigt das Emissionsspektrum der gleichen LED nach einer Betriebsdauer von 1000 Stunden bei einer Umgebungstemperatur von 80 °C und einer Luftfeuchtigkeit von 85 %. Zu diesem Zeitpunkt hat die Helligkeit der LED um ca. 18 % abgenommen.
- **Fig. 3:**: zeigt eine Auftragung der Helligkeit von zwei Test-LEDs gegen die Zeit. Die LEDs werden über den gesamten Zeitraum mit 20 mA konstant bestromt, die Temperatur beträgt während des gesamten Experiments 80 ± 1 °C, die relative Luftfeuchtigkeit 85 ± 3 %. Die Kurve 1 zeigt den Helligkeitsverlauf des ortho-Silicatleuchtstoffs aus Stufe 1 von Beispiel 1, während Kurve 2 den Helligkeitsverlauf des erfindungsgemäßen ortho-Silicatleuchtstoffs aus Stufe 2 von Beispiel 1 wiedergibt. Man erkennt deutlich die signifikant gesteigerte Stabilität des erfindungsgemäßen Silicat-Leuchtstoffs aus Stufe 2 von Beispiel 1, die Abnahme der Helligkeit beträgt lediglich 5 %, gegenüber den bereits erwähnten 18 % für den üblichen ortho-Silicatleuchtstoff aus Stufe 1 von Beispiel 1.

## Patentansprüche

1. Verbindung der Formel I
EA₂₋ₓEuₓSiO₄ • a M₂B₄O₇ (I)
wobei
EA für zwei oder mehrere Elemente, ausgewählt aus Ca, Sr, Zn und Ba steht,
M für Li, Na oder K steht, und
a für einen Wert aus dem Bereich 0.01 ≤ a ≤ 0.08 und
x für einen Wert aus dem Bereich 0.01 ≤ x ≤ 0.25 steht.

2. Verbindung nach Anspruch 1, **dadurch gekennzeichnet, dass** x für einen Wert aus dem Bereich 0.03 ≤ x ≤ 0.20, vorzugsweise aus dem Bereich 0.04 ≤ x ≤ 0.13 steht.

3. Verbindung nach Anspruch 1 oder 2, **dadurch gekennzeichnet, dass** a für einen Wert aus dem Bereich 0.01 ≤ a ≤ 0.05 steht.

4. Verfahren zur Herstellung einer Verbindung gemäß einem oder mehreren der Ansprüche 1 bis 3, umfassend folgende Verfahrensschritte:
a) Bereitstellung einer M₂B₄O₇-haltigen Lösung, wobei M = Li, Na oder K bedeutet (Lösung A)
b) Bereitstellen eines Leuchtstoffes der Zusammensetzung EA₂₋ₓEuₓSiO₄, wobei EA für zwei oder mehrere Elemente, ausgewählt aus Ca, Sr, Zn und Ba, steht und x für einen Wert aus dem Bereich 0.01 ≤ x ≤ 0.25 steht (Leuchtstoff B)
c) Zugabe und inniges Vermischen des Leuchtstoffes B mit der Lösung A,
d) Waschen, und
e) anschließende Trocknung.

5. Mischung, enthaltend mindestens eine Verbindung nach einem oder mehreren der Ansprüche 1 bis 3 und mindestens einen weiteren Leuchtstoff.

6. Mischung nach Anspruch 5, **dadurch gekennzeichnet, dass** der mindestens eine weitere Leuchtstoff mindestens ein rot emittierender Leuchtstoff, ausgewählt aus der Gruppe, bestehend aus Eu-dotierten Sulfoseleniden, Eu- und/oder Ce-dotierten Nitriden, Oxynitriden, Alumosiliconitriden und/oder Mn(IV) dotierten Oxiden und/oder Fluoriden ist.

7. Lichtquelle, **dadurch gekennzeichnet, dass** sie einen Halbleiter und mindestens eine Verbindung gemäß einem oder mehreren der Ansprüche 1 bis 3 enthält.

8. Lichtquelle nach Anspruch 7, **dadurch gekennzeichnet, dass** es sich bei dem Halbleiter um ein lumineszentes IndiumAluminiumGallium-Nitrid, insbesondere der Formel InᵢGaⱼAlₖN, wobei 0 ≤ i, 0 ≤ j, 0 ≤ k, und i+j+k=1 handelt.

9. Beleuchtungseinheit, insbesondere zur Hintergrundbeleuchtung von Anzeigevorrichtungen, **dadurch gekennzeichnet, dass** sie mindestens eine Lichtquelle nach den Ansprüchen 7 oder 8 enthält.

10. Anzeigevorrichtung, insbesondere Flüssigkristallanzeigevorrichtung (LC-Display), **dadurch gekennzeichnet, dass** sie mindestens eine Beleuchtungseinheit nach Anspruch 9 enthält.

11. Verwendung mindestens einer Verbindung nach einem oder mehreren der Ansprüche 1 bis 3 als Konversionsleuchtstoff, vorzugsweise zur teilweisen oder vollständigen Konversion der blauen oder im nahen UV-liegenden Emission einer Lumineszenzdiode, oder in Elektrolumineszenz-Materialien, insbesondere in Elektrolumineszenz-Folien.

## Claims

1. Compound of the formula I
EA₂₋ₓEuₓSiO₄ • a M₂B₄O₇ (I)
where
EA stands for two or more elements selected from Ca, Sr, Zn and Ba,
M stands for Li, Na or K, and
a stands for a value from the range 0.01 ≤ a ≤ 0.08, and
x stands for a value from the range 0.01 ≤ x ≤ 0.25.

2. Compound according to Claim 1, **characterised in that** x stands for a value from the range 0.03 ≤ x ≤ 0.20, preferably from the range 0.04 ≤ x ≤ 0.13.

3. Compound according to Claim 1 or 2, **characterised in that** a stands for a value from the range 0.01 ≤ a ≤ 0.05.

4. Process for the preparation of a compound according to one or more of Claims 1 to 3, comprising the following process steps:
a) provision of an M₂B₄O₇-containing solution, where M = Li, Na or K (solution A)
b) provision of a phosphor of the composition EA₂₋ₓEuₓSiO₄, where EA stands for two or more elements selected from Ca, Sr, Zn and Ba, and x stands for a value from the range 0.01 ≤ x ≤ 0.25 (phosphor B)
c) addition and intimate mixing of phosphor B with solution A,
d) washing, and
e) subsequent drying.

5. Mixture comprising at least one compound according to one or more of Claims 1 to 3 and at least one further phosphor.

6. Mixture according to Claim 5, **characterised in that** the at least one further phosphor is at least one red-emitting phosphor selected from the group consisting of Eu-doped sulfoselenides, Eu- and/or Cedoped nitrides, oxynitrides, alumosiliconitrides and/or Mn(IV)-doped oxides and/or fluorides.

7. Light source, **characterised in that** it comprises a semiconductor and at least one compound according to one or more of Claims 1 to 3.

8. Light source according to Claim 7, **characterised in that** the semiconductor is a luminescent indium aluminium gallium nitride, in particular of the formula InᵢGaⱼAlₖN, where 0 ≤ i, 0 ≤ j, 0 ≤ k, and i + j + k = 1.

9. Lighting unit, in particular for the backlighting of display devices, **characterised in that** it comprises at least one light source according to Claim 7 or 8.

10. Display device, in particular liquid-crystal display device (LC display), **characterised in that** it comprises at least one lighting unit according to Claim 9.

11. Use of at least one compound according to one or more of Claims 1 to 3 as conversion phosphor, preferably for the partial or complete conversion of the blue or near-UV emission from a luminescent diode, or in electroluminescent materials, in particular in electroluminescent films.

## Revendications

1. Composé de la formule I
EA₂₋ₓEuₓSiO₄ • a M₂B₄O₇ (I)
dans laquelle
EA représente deux éléments ou plus choisis parmi Ca, Sr, Zn et Ba,
M représente Li, Na ou K, et
a représente une valeur de la plage 0,01 ≤ a ≤ 0,08, et
x représente une valeur de la plage 0,01 ≤ x ≤ 0,25.

2. Composé selon la revendication 1, **caractérisé en ce que** x représente une valeur de la plage 0,03 ≤ x ≤ 0,20, de façon préférable de la plage 0,04 ≤ x ≤ 0,1 3.

3. Composé selon la revendication 1 ou 2, **caractérisé en ce que** a représente une valeur de la plage 0,01 ≤ a ≤ 0,05.

4. Procédé pour la préparation d'un composé selon une ou plusieurs des revendications 1 à 3, comprenant les étapes de procédé qui suivent :
a) fourniture d'une solution contenant du M₂B₄O₇, où M = Li, Na ou K (solution A)
b) fourniture d'un phosphore de la composition EA₂₋ₓEuₓSiO₄, où EA représente deux éléments ou plus choisis parmi Ca, Sr, Zn et Ba, et x représente une valeur de la plage 0,01 ≤ x ≤ 0,25 (phosphore B)
c) ajout et mélange intime du phosphore B avec la solution A,
d) lavage, et
e) séchage ensuite.

5. Mélange comprenant au moins un composé selon une ou plusieurs des revendications 1 à 3 et au moins un autre phosphore.

6. Mélange selon la revendication 5, **caractérisé en ce que** l'au moins un autre phosphore est au moins un phosphore émetteur de rouge choisi parmi le groupe constitué par des sulfoséléniures dopés à l'Eu, des nitrures, oxynitrures, alumosiliconitrures dopés à l'Eu et/ou au Ce, et/ou des oxydes et/ou fluorures dopés au Mn(IV).

7. Source de lumière, **caractérisée en ce qu'**elle comprend un semiconducteur et au moins un composé selon une ou plusieurs des revendications 1 à 3.

8. Source de lumière selon la revendication 7, **caractérisée en ce que** le semiconducteur est un nitrure d'indium aluminium gallium luminescent, en particulier de la formule InᵢGaⱼAlₖN, où 0 ≤ i, 0 ≤ j, 0 ≤ k, et i+j+k=1.

9. Unité d'éclairage, en particulier pour l'éclairage arrière de dispositifs d'affichage, **caractérisée en ce qu'**elle comprend au moins une source de lumière selon la revendication 7 ou 8.

10. Dispositif d'affichage, en particulier dispositif d'affichage à cristaux liquides (affichage LC), **caractérisé en ce qu'**il comprend au moins une unité d'éclairage selon la revendication 9.

11. Utilisation d'au moins un composé selon une ou plusieurs des revendications 1 à 3 en tant que phosphore de conversion, de préférence pour la conversion partielle ou complète de l'émission de bleu ou des UV proches en provenance d'une diode luminescente, ou dans des matériaux électroluminescents, en particulier dans des films électroluminescents.
